# FASCICULE DE BREVET EUROPEEN

(11) **EP 1 108 677 B1**
(45) Date de publication et mention de la délivrance du brevet: **27.09.2006**
(21) Numéro de dépôt: 99125008.5
(22) Date de dépôt: 15.12.1999
(51) Int. Cl.: B81B 7/00, H01L 21/50, H01L 23/10, H01L 23/31

(54) **Procédé d'encapsulation hermétique in situ de microsystèmes**
Hermetische In-Situ-Gehäusungsmethode von Mikrosystemen
Method of hermetic In Situ encapsulation of microsystems

(43) Date de publication de la demande: 20.06.2001
(73) Titulaire: ASULAB S.A., 2074 Marin (CH)
(72) Inventeur: Gueissaz, François, 2075 Wavre (CH)
(74) Mandataire: Laurent, Jean

(56) Documents cités:
- DE-A- 19 735 041
- US-A- 5 548 099

## Description

L'invention concerne un procédé d'encapsulation hermétique in situ de microsystèmes. Au moins un microsystème monté sur un substrat est encapsulé sous une capsule métallique réalisée in situ. On entend par montage soit le placement du microsystème, réalisé préalablement, sur le substrat, soit la réalisation in situ du microsystème sur le substrat. De préférence, plusieurs microsystèmes sont fabriqués en commun sur le même substrat dans des dimensions micrométriques. L'encapsulation enfermant le microsystème doit être hermétique et laisser ledit microsystème libre de mouvements à l'intérieur de la capsule.

On entend par microsystèmes des structures tridimensionnelles, c'est-à-dire des dispositifs micro-optoélectromécaniques (MOEMS) ou des dispositifs microélectromécaniques (MEMS) tels que des contacteurs reed, des accéléromètres, des micromoteurs, des capteurs de taille micrométrique où il est nécessaire de les laisser libres de mouvements après encapsulation. La construction desdits microsystèmes peut se faire sur un substrat isolant ou sur un substrat dont des circuits intégrés ont été préalablement réalisés. Dans ce dernier cas, il est possible de prendre les plages de contact métallique du circuit intégré pour débuter le dépôt des couches métalliques devant constituer en partie le microsystème et pour permettre de le relier électriquement audit circuit.

Dans le brevet CH 688213 du même demandeur, il est décrit un contacteur « reed » ou à lames de taille micrométrique et son procédé de réalisation dans lequel des lames métalliques distantes l'une de l'autre à l'état de repos sont réalisées par voie électrolytique en plusieurs étapes et sont solidaires d'un plan de base. Les lames sont constituées d'un alliage de fer et de nickel, déposé par procédé électrolytique, qui a la propriété d'être ferromagnétique de façon à pouvoir être mises en contact l'une avec l'autre lorsqu'un champ magnétique les traversant crée une force d'attraction entre elles. Ce contacteur est encapsulé sous un couvercle creux qui est fixé par exemple à l'aide d'une colle epoxy sur le plan de base qui peut être un substrat en verre ou une couche isolante obtenue par oxydation de la surface d'un substrat en silicium. Le couvercle est constitué d'une plaque en verre dans laquelle des cavités sont formées par gravure chimique. Cette plaque permet d'enfermer chaque contacteur dans chacune des cavités créées. Elle peut être collée sur le plan de base ou être soudée par une soudure eutectique ou anodique. Dans une opération finale, la multitude de contacteurs ainsi réalisés et scellés sont séparés par sciage.

Dans ce type de réalisation, il est nécessaire d'usiner la plaque de verre séparément du substrat sur lequel sont fabriqués les contacteurs, ce qui est un inconvénient. De plus, la plaque doit être collée avec précision sur le plan de base à l'aide d'epoxy, et le scellement n'est pas hermétique à long terme, car l'epoxy absorbe l'eau et dégaze des substances susceptibles de perturber le fonctionnement du contacteur. Dans d'autres modes de réalisation, le traitement thermique peut être destructif.

On note encore dans la réalisation d'un contacteur encapsulé sous une cloche en verre comme décrit dans ce document CH 688213 lors de mesures de résistances de contact entre les lames métalliques que, avant encapsulation du contacteur, la moyenne des résistances de contact de tous les contacteurs réalisés sur un même substrat était bien centrée autour de 10 ohms, alors qu'après ladite encapsulation, on a mesuré que cette moyenne des résistances de contact s'élevait de 10 à 60 ohms.

Dans le document EP 302165, il est spécifié que l'on forme par estampage une feuille d'étain pour servir de cloche métallique à un circuit intégré, que l'on vient coller cette estampe sur une plaque de base où est placé le circuit intégré de façon à fermer ledit circuit sous la cloche, et que l'on revêt le tout d'une couche de polyéthylène. La colle, comme expliqué ci-dessus, peut causer une contamination du microsystème et de ce fait ne permet de garantir une encapsulation hermétique. Il n'est pas possible en outre de concevoir in situ la cloche par estampage. De plus, la réalisation de ces estampes, qu'il faut placer individuellement sur chaque microsystème, compliquerait la réalisation d'une encapsulation de plusieurs microsystèmes montés sur un même substrat.

Dans le domaine combinant des dispositifs micromécaniques et électroniques, l'utilisation de couches sacrificielles est déjà connue, notamment dans le cas où l'on souhaite par exemple faire un pont métallique entre un circuit intégré et un capteur, mais pas dans le cas de la réalisation d'une encapsulation métallique hermétique de microsystèmes.

Le document US 5798283 décrit un procédé de fabrication d'au moins un dispositif microélectromécanique avec un circuit électronique. Une cavité est gravée dans le substrat par exemple en silicium afin d'y loger le dispositif micromécanique. Ce dernier est construit à l'aide de différentes couches de polysilicium afin d'obtenir des éléments pouvant être libres de mouvements. Le dispositif doit être protégé à l'aide de couches d'oxyde ou de nitrure de silicium afin de pouvoir réaliser les étapes de réalisation du circuit intégré ultérieures. Cette protection du dispositif micromécanique est nécessaire contre des températures de diffusion de dopants (bore, phosphore par exemple) qui s'élèvent à plus de 700°C, ce qui peut détruire en partie les éléments dudit dispositif micromécanique conçus avec certains métaux à bas point de fusion, et également pouvoir éviter de doper lesdits éléments s'il s'agit de polysilicium.

Une fois les opérations du circuit intégré terminées, deux ouvertures sur une couche de protection au-dessus des couches de SiO2 ou de Si3N4 permettent de retirer par gravure chimique en partie lesdites couches de SiO2 ou Si3N4 afin de libérer le dispositif micromécanique et de le laisser libre de mouvements. Lors de ce retrait, des précautions doivent être prises pour éviter une gravure latérale trop importante, du fait que le circuit intégré est construit à côté du dispositif micromécanique.

Il aurait pu être imaginé, au lieu de pratiquer deux ouvertures dans la couche de protection, d'utiliser uniquement une couche de polysilicium poreux afin de retirer les couches de SiO2 ou Si3N4 par attaque chimique, notamment avec de l'acide fluorhydrique, à travers le polysilicium, et ensuite rincer avec de l'eau déionisée.

On tire enseignement de ce document, que l'encapsulation se fait à l'aide de couches autres que métalliques, qu'une cavité est usinée au préalable dans le substrat pour y loger le microsystème par des techniques de gravure similaire à celles utilisées dans le domaine de la microélectronique, et que surtout il est nécessaire de protéger le microsystème pendant la réalisation du circuit intégré correspondant avec des couches supportant des températures élevées. De ce fait, il n'est pas question de déposer des couches métalliques notamment par voie électrolytique sur ledit dispositif micromécanique pour la création d'une encapsulation métallique hermétique.

Il est décrit dans le document EP 435530 un système électronique hermétiquement scellé par des couches métalliques dont l'une est déposée par voie électrolytique. Le système électronique est une association de différents circuits intégrés, dont l'interconnexion est à haute densité (HDI), collés et logés dans une cavité micro-usinée dans un substrat en verre ou en céramique. Une première couche métallique, notamment en chrome ou titane, est pulvérisée sur une couche de diélectrique qui surplombe les interconnexions réalisées pour les différents circuits, de façon à enrober toute la structure et à venir en contact à même la surface du substrat. Par la suite, on dépose par voie électrolytique une seconde couche métallique par dessus la première couche afin de créer une couche de protection plus épaisse contre divers contaminants pouvant perturber les circuits.

Le document EP 435530 n'apporte aucun enseignement pour la réalisation d'une encapsulation de microsystèmes, tels que des contacteurs de type « reed », car on ne veut pas de polymères qui ont le désavantage de produire des gaz, c'est-à-dire de dégazer, et donc de créer des défauts qui seront perceptibles sur le bon fonctionnement du contacteur. De plus, il est à noter qu'il n'est pas envisagé de créer une capsule métallique par le biais d'une couche métallique sacrificielle retirée après le dépôt d'une couche métallique subséquente constituant la capsule.

Un but que se propose de résoudre ladite invention consiste à réaliser une encapsulation hermétique in situ de microsystèmes en palliant les inconvénients de l'art antérieur cité ci-dessus.

Un autre but de la présente invention est de pouvoir réaliser une capsule métallique par électrodéposition de couches métalliques pour l'encapsulation de microsystèmes à des températures inférieures à 350°C maximum, ce qui se différencie d'étapes de procédé de fabrication de circuits intégrés où notamment la diffusion de phosphore ou de bore se fait à des températures dépassant 700°C et pouvant atteindre même 1300°C, ce qui est bien supérieur à la température indiquée ci-dessus.

Un autre but que se propose de résoudre le procédé objet de l'invention est d'éviter d'avoir une aussi grande dispersion des valeurs de résistance de contact après encapsulation hermétique, dans le cas où le microsystème est un contacteur, et de laisser le microsystème dans une atmosphère inerte ou réductrice.

Ces buts, ainsi que d'autres, sont atteints grâce au procédé d'encapsulation hermétique in situ de microsystèmes dans lequel, dans une première phase, on monte sur un substrat commun plusieurs microsystèmes entourés par une couche métallique d'accrochage déposée sur le substrat, le procédé se caractérisant en ce que, dans une deuxième phase, on dépose dans une opération commune de dépôt une première couche métallique sur chaque microsystème et sur une zone annulaire de la couche d'accrochage entourant chaque microsystème de façon à recouvrir complètement chaque microsystème par débordement, en ce qu'on dépose une deuxième couche métallique par voie électrolytique sur la première couche métallique et sur la couche d'accrochage de façon à recouvrir la première couche sur une majeure partie de sa surface en laissant au moins un passage par microsystème dans la deuxième couche pour donner accès à la première couche, le métal de la première couche étant différent des métaux de la couche d'accrochage, de la deuxième couche et du microsystème, en ce qu'on retire par gravure chimique sélective la première couche au travers de chaque passage de la deuxième couche, et en ce qu'on referme chaque passage de la deuxième couche pour obtenir des capsules métalliques enfermant hermétiquement chaque microsystème.

Un avantage du procédé de l'invention consiste à réaliser une encapsulation métallique hermétique par des moyens qui permettent de traiter simultanément des substrats sur lesquels plusieurs microstructures ont été fabriquées ou montées.

Un autre avantage du procédé de l'invention réside en ce que le maintien de la capsule métallique réalisée sur le substrat et enfermant le microsystème est obtenu sans l'aide de colles pouvant contenir des polymères susceptibles de dégazer des contaminants à l'intérieur de la capsule métallique, risquant de perturber le microsystème.

Pour cela, il a été imaginé de créer une encapsulation métallique de microsystèmes à l'aide de dépôts de métaux, dont une des couches métalliques sert de couche sacrificielle, et dont au moins la couche métallique finale est déposée par voie électrolytique, sur une couche d'accrochage métallique ayant une bonne adhérence à la surface isolante du substrat.

Pour la réalisation de cette capsule, une première couche métallique, dénommée couche sacrificielle, est déposée, de préférence par voie électrolytique, sur l'ensemble des microsystèmes et sur des zones annulaires de la couche d'accrochage entourant chaque microsystème de façon à recouvrir complètement chaque microsystème par débordement. Après le dépôt de cette première couche métallique, les microsystèmes revêtus ont un aspect en forme de dôme. Une deuxième couche métallique est ensuite déposée par voie électrolytique sur la première couche avec des passages donnant accès à la première couche.

La première couche métallique est constituée d'un métal différent des métaux constituant la deuxième couche, la couche d'accrochage et également du microsystème, de façon à pouvoir servir de couche sacrificielle et pouvoir être sélectivement retirée par gravure chimique au travers d'au moins un passage pratiqué dans la deuxième couche métallique afin de réaliser la capsule métallique. Dans une étape finale de l'encapsulation, il est nécessaire d'obturer le ou les passages pratiqués dans la deuxième couche afin de sceller la capsule hermétiquement en maintenant le microsystème dans une atmosphère inerte ou réductrice à l'intérieur de la capsule.

On comprend par métal également tous les alliages métalliques dépendant d'un métal particulier.

Cette technique d'électrodéposition permet d'avoir une encapsulation de haute qualité et à faible coût pour les microsystèmes.

Un autre avantage du procédé de l'invention est qu'il permet d'éviter de devoir protéger le microsystème pour la réalisation subséquente du circuit intégré à ses côtés comme décrit dans le document US 5798283. Dans le cas par exemple d'un microcontacteur, ces étapes d'encapsulation se font même à température ambiante.

Dans une phase préliminaire du procédé, on peut par exemple réaliser sur un substrat, dont au moins la surface est isolante, des bandes conductrices pour la connexion électrique du microsystème vers l'extérieur, une isolation de la partie médiane des bandes et une métallisation de surface connectant une extrémité des bandes et passant également au-dessus de l'isolation des bandes. Egalement dans cette première phase du procédé, le microsystème à encapsuler est monté sur le substrat. Dans une deuxième phase, il est formé la capsule métallique avec la fermeture de ses orifices. Le découpage du substrat peut être exécuté par la suite pour obtenir une multitude de microsystèmes encapsulés.

L'invention sera mieux comprise en regard des dessins montrant des exemples de réalisation non limitatifs du procédé objet de l'invention sur lesquels :
la figure 1a montre la première phase du procédé selon l'invention avec une partie d'un substrat sur lequel on a réalisé des bandes conductrices avec isolation, une couche d'accrochage et un microsystème,
la figure 1b montre la première phase du procédé selon l'invention avec une partie d'un substrat sur lequel on a réalisé des bandes conductrices avec isolation, une couche d'accrochage avec des plots de soudure et un microsystème,
les figures 2a et 2b montrent en vue de dessus et en coupe selon II-II le dépôt d'une couche métallique sacrificielle sur le microsystème et sur la couche d'accrochage selon une première forme d'exécution,
les figures 3a et 3b montrent en vue de dessus et en coupe selon III-III le dépôt d'une deuxième couche métallique par-dessus la couche sacrificielle qui est constituée d'un métal différent et selon une première forme d'exécution,
les figures 4a et 4b montrent en vue de dessus et en coupe selon IV-IV le retrait de la couche sacrificielle par gravure chimique au travers des passages de la capsule ainsi réalisée selon une première forme d'exécution,
les figures 5a, 5b et 5c montrent en vue de dessus et en coupe selon V-V la fermeture des passages de la capsule métallique de façon à encapsuler hermétiquement le microsystème selon une première forme d'exécution,
les figures 6a et 6b montrent en vue de dessus et en coupe selon VI-VI le dépôt d'une couche sacrificielle sur le microsystème et sur la couche d'accrochage qui comprend des plots de soudure selon une deuxième forme d'exécution,
les figures 7a, 7b et 7c montrent en vue de dessus et en coupe selon VII-VII et VIII-VIII le dépôt d'une deuxième couche métallique par-dessus la couche sacrificielle qui est constituée d'un métal différent selon une deuxième forme d'exécution,
la figure 8 montre une coupe selon VII-VII de la figure 7a après le retrait de la couche sacrificielle par gravure chimique par les passages de la deuxième couche selon une deuxième forme d'exécution,
la figure 9 montre une coupe selon VII-VII de la figure 7a de la fermeture des passages de la capsule métallique du microsystème selon une deuxième forme d'exécution,
la figure 10 montre en coupe verticale le dépôt d'une couche sacrificielle sur le microsystème et sur la couche d'accrochage selon une troisième forme d'exécution,
la figure 11 montre en coupe verticale les dépôts d'une deuxième et troisième couche métallique sur la couche sacrificielle selon une troisième forme d'exécution,
la figure 12 montre en coupe verticale le dépôt d'une quatrième couche métallique du même métal que la deuxième couche sur la troisième couche métallique selon une troisième forme d'exécution,
la figure 13 montre en coupe verticale le retrait de la couche sacrificielle par gravure chimique par les passages de la deuxième couche selon une troisième forme d'exécution,
la figure 14 montre en coupe verticale l'apport de gouttes de soudure sur les passages de la deuxième couche pour la fermeture de la capsule métallique selon une troisième forme d'exécution,
la figure 15 montre en coupe verticale la fermeture de la capsule métallique avec les gouttes de soudure solidifiées selon une troisième forme d'exécution,
les figures 16a, 16b et 16c montrent en vue de dessus et en coupe selon XVI-XVI et XVII-XVII le dépôt d'une couche métallique sacrificielle sur le microsystème et sur la couche d'accrochage et passant autour de plots de soudure de la couche d'accrochage selon une quatrième forme d'exécution,
la figure 17 montre en coupe selon XVI-XVI de la figure 16a le dépôt d'une deuxième couche métallique sur la couche sacrificielle et sur les plots de soudure de la couche d'accrochage selon une quatrième forme d'exécution,
la figure 18 montre en coupe selon XVI-XVI de la figure 16a le retrait de la couche sacrificielle par les passages de la deuxième couche entre les plots de soudure selon une quatrième forme d'exécution,
la figure 19 montre en coupe selon XVI-XVI de la figure 16a la fermeture de la capsule métallique par chauffage des plots de soudure selon une quatrième forme d'exécution,
les figures 20a et 20b montrent en vue de dessus et en coupe selon XX-XX le retrait de la couche sacrificielle au travers d'une multitude de passages dans la deuxième couche selon une cinquième forme d'exécution, et
la figure 21 montre en coupe selon XX-XX de la figure 20a la fermeture de la capsule métallique par une lame de fluide de soudure selon une cinquième forme d'exécution.

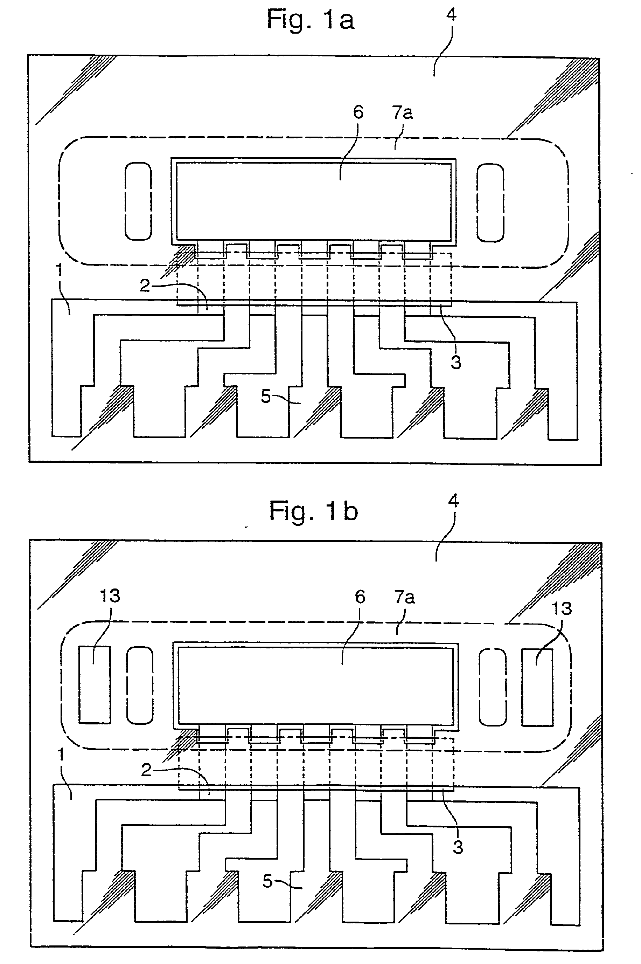

Les figures 1 à 5 montrent les différentes étapes de l'encapsulation hermétique in situ de microsystèmes selon une première forme d'exécution du procédé de l'invention. A titre de simplification, un seul microsystème est représenté sur lesdites figures, alors qu'en réalité plusieurs microsystèmes sont montés sur un substrat commun afin d'être encapsulés en même temps.

Aux figures 1a et 1b, on observe une partie d'un substrat 1, qui peut être entièrement isolant comme une plaque de verre ou de céramique, ou un substrat, par exemple en silicium, dont la surface est oxydée pour être isolante. Les dimensions du substrat peuvent être celles d'un substrat de silicium sur lequel on conçoit des circuits intégrés, par exemple de 6 pouces (152,4 mm). Cette partie du substrat visible aux figures 1a et 1b correspond aux dimensions pour un des microsystèmes réalisés en commun sur le même substrat.

Dans une première phase du procédé vue aux figures 1a et 1b, une couche conductrice est déposée tout d'abord sur la surface isolante du substrat 1 et est structurée de façon à former des bandes conductrices 2. Une couche isolante 3 est ensuite déposée uniquement sur la partie médiane des bandes conductrices 2 pour former ainsi des passages électriques isolés. Finalement, une couche métallique d'accrochage 4 est déposée sur le substrat en passant sur la couche d'isolation 3 afin de donner une métallisation de surface apte à définir des bornes électriques 5 reliées uniquement à une des extrémités des bandes conductrices pour la connexion électrique du microsystème après sciage du substrat. Cette couche d'accrochage est apte à supporter la construction du microsystème et de la capsule. Elle forme finalement un plan conducteur pour les étapes de dépôt électrolytique qui permettent d'obtenir des couches métalliques d'épaisseur importante.

La couche conductrice constituant les bandes conductrices 2 doit avoir une bonne adhérence sur le substrat et permettre une bonne adhérence de la couche isolante subséquente 3. Elle doit également être compatible avec la couche métallique d'accrochage 4 et posséder une faible résistance électrique à l'interface. II est important que les bords d'attaque ne possèdent pas de pente négative, ou ne forment pas une corniche, cela afin que la couche d'isolation les recouvre parfaitement. Les bandes conductrices 2 peuvent être en matériau tel que l'aluminium, l'or, le titane, le cuivre, le chrome, le tungstène ou l'alliage titane-tungstène. Ces bandes sont utiles pour la connexion électrique externe du microsystème après son encapsulation.

La couche d'isolation doit avoir une bonne adhérence sur le substrat isolant 1 et sur les bandes conductrices 2, par exemple comme une couche d'oxyde de silicium ou de nitrure Si3N4. De plus, elle doit contenir peu de tensions internes, posséder un coefficient de dilatation proche de celui du substrat et recouvrir parfaitement les bords d'attaque des bandes conductrices.

La couche métallique d'accrochage 4 doit bien adhérer sur le substrat 1 et la couche d'isolation 3. On peut la réaliser comme le document CH 688213 le spécifie, c'est-à-dire en faisant d'abord un dépôt de titane ou de chrome qui est ensuite recouvert d'or qui sert de protection d'oxydation. Cette deuxième couche métallique sert de surface de base métallique pour le dépôt par voie galvanique des couches métalliques subséquentes. Les produits de gravure chimique pour structurer ces premières couches métalliques sont connus et ne seront de ce fait pas explicités. Une zone annulaire 7a est montrée en traits interrompus sur les figures 1a et 1b pour montrer l'endroit du dépôt d'une couche métallique subséquente.

Au cas où de la soudure est employée sur la couche d'accrochage, il est nécessaire de prévoir une couche de base de la couche d'accrochage faite de trois niveaux métalliques. Le premier niveau métallique est composé de titane ou de chrome et permet d'accrocher au substrat. Le deuxième niveau métallique est composé de nickel ou de palladium ou de rhodium ou de ruthénium ou de platine ou de molybdène ou d'un autre matériau afin de servir de barrière de diffusion s'il y a de la soudure. Enfin le troisième niveau métallique est composé d'or pour servir de protection d'oxydation, notamment du premier niveau métallique.

A la figure 1b, des plots de soudure 13 en alliage d'or et d'étain (Au-Sn) ou en alliage d'étain et de plomb (Sn-Pb) peuvent faire également partie de la couche d'accrochage à des endroits déterminés afin de servir comme on le verra plus loin à une meilleure fermeture des passages pratiqués dans la capsule métallique lors de la thermocompression de parties de la capsule sur lesdits plots. L'alliage d'or et d'étain est constitué, en masses, de 20% d'étain et 80% d'or, tandis que l'alliage d'étain et de plomb est constitué, en masses, de 60% d'étain et 40% de plomb.

Dans des formes d'exécution non représentées sur des figures, en lieu et place des bandes conductrices 2, on aurait pu réaliser des trous conducteurs traversant des parties isolantes du substrat ou le substrat s'il est entièrement isolant tel qu'une plaque en verre ou en céramique, ou des trous conducteurs isolés dans un substrat conducteur. D'un côté du substrat ces trous connectent le microsystème 6 et de l'autre côté ils sont reliés électriquement à des plages métalliques permettant de connecter le microsystème à l'extérieur une fois qu'il est encapsulé.

Il est clair que l'étape d'isolation 3 des bandes conductrices 2 n'entre pas en ligne de compte si l'on a pratiqué des trous conducteurs au travers du substrat comme dans la forme d'exécution indiquée ci-dessus.

Dans le cas où les bandes conductrices 2 sont remplacées par les trous conducteurs, notamment des trous métallisés, la couche d'accrochage n'est plus structurée pour définir des pistes métalliques avec des plages métalliques de connexion électrique du microsystème du fait que ces plages sont réalisées au dos du substrat. Il suffit que cette couche d'accrochage entoure chaque microsystème pour le dépôt par voie électrolytique des couches métalliques de réalisation de la capsule.

Au cas où un substrat en silicium est employé comme support pour les microsystèmes, les bandes conductrices déposées sur le substrat peuvent être remplacées par des passages conducteurs dans le silicium. Ces passages sont réalisés par une étape de diffusion avec un dopant de type p dans un substrat de type n ou avec un dopant de type n dans un substrat de type p. La connexion métallique de chaque extrémité desdits passages conducteurs est réalisée à travers des fenêtres pratiquées sur une isolation en oxyde de silicium. Un avantage de cette réalisation est qu'elle assure une protection électrostatique.

Le microsystème 6, qui peut être par exemple un contacteur « reed », est construit ou monté sans endommager les couches précédentes déjà déposées. Pour la construction d'un contacteur avec ces lames métalliques, on utilise également des techniques de dépôt électrolytique, par exemple en structurant les niveaux métalliques en plusieurs étapes à l'aide de photorésist et des masques pour les illuminer, comme décrit dans le document CH 688213. Le microsystème ainsi réalisé est connecté à une extrémité des bandes conductrices 2 ou à des trous conducteurs.

A la place d'une réalisation in situ desdits microsystèmes, on peut prévoir de les fabriquer à part et ensuite de les fixer chacun sur un même substrat en connexion électrique à une extrémité des bandes conductrices ou des trous conducteurs prévus à cet effet.

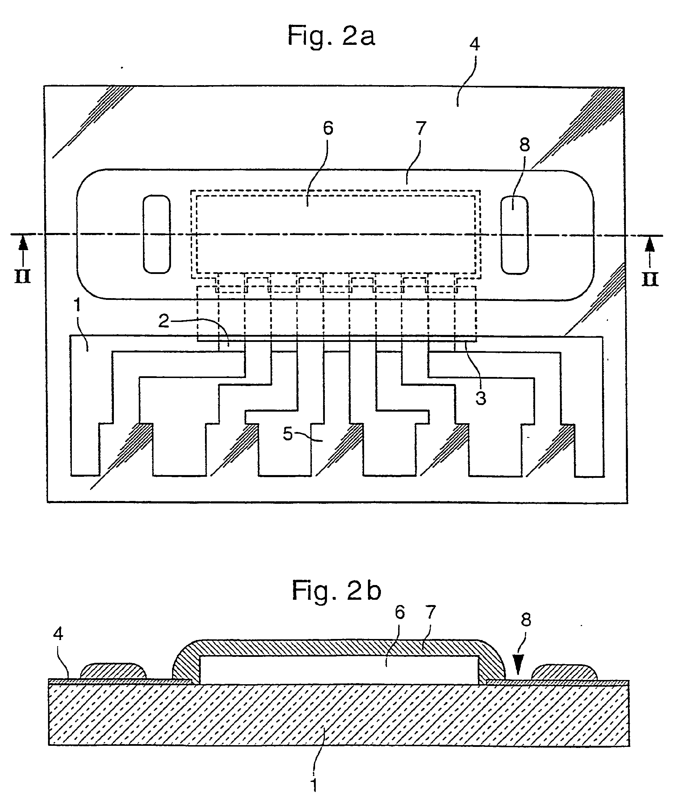

Aux figures 2a et 2b, une première couche métallique d'enrobage sacrificielle 7, notamment en cuivre ou en alliage de cuivre, est déposée notamment par voie électrolytique sur les microsystèmes et en débordant sur des zones annulaires 7a, visibles aux figures 1a et 1b, autour de chaque microsystème de façon à ce que la première couche enrobe complètement chaque microsystème. Etant donné que la couche d'accrochage métallique n'est pas dissociée d'un microsystème à l'autre, elle peut être utilisée pour le dépôt électrolytique des diverses parties de la première couche enrobant tous les microsystèmes en la connectant à un endroit du substrat à un pôle d'une source d'alimentation. Dans cette réalisation, une ou deux ouvertures 8 sont également prévues dans chaque zone annulaire, donnant accès à la couche d'accrochage 4 pour servir à la formation d'un ou de deux piliers métalliques de soutien lors du dépôt de la couche métallique suivante.

Cette première couche sacrificielle 7 est composée d'un métal, tel que du cuivre ou un alliage de cuivre, qui peut être dissous sélectivement par rapport aux autres couches métalliques qui sont constituées de métaux différents. Elle doit contenir peu de tensions internes et présenter une bonne caractéristique de nivelage.

Pour le dépôt électrolytique de cette couche sacrificielle, on revêt tout d'abord les microsystèmes et la couche d'accrochage d'une couche de photorésist. On illumine le photorésist au travers d'un masque, et on retire par développement les parties du photorésist qui ont été illuminées ou non illuminées suivant le type de photorésist, pour pouvoir libérer chaque microsystème ainsi qu'une zone annulaire de la couche d'accrochage autour de chaque microsystème afin de déposer la première couche métallique. Par la suite on retire le reste de photorésist pour avoir accès à la couche d'accrochage autour de l'enrobage de chaque microsystème et par les ouvertures pratiquées dans la première couche. Une partie de la zone annulaire de la couche d'accrochage est située au-dessus de l'isolation 3 des bandes conductrices de façon que le dépôt de la couche métallique sacrificielle court-circuite uniquement les extrémités des bandes connectant les microsystèmes.

Pour la création de ces dômes métalliques enrobant chaque microsystème, on peut prévoir de déposer la couche métallique par un procédé autre que la voie électrolytique, par exemple par évaporation thermique ou par pulvérisation cathodique sans devoir dépasser la limite de température de 350°C, mais ces autres procédés sont plus longs et donc plus coûteux.

Les ouvertures 8 de la première couche métallique visibles aux figures 2a et 2b sont entourées complètement par la première couche, mais il est bien entendu qu'on aurait pu les concevoir prenant naissance depuis un bord de ladite première couche pour donner l'aspect vu en plan d'une ouverture en forme de U. L'homme du métier saura trouver toute forme d'ouvertures permettant la création de piliers ou de renforts lors du dépôt de la deuxième couche métallique.

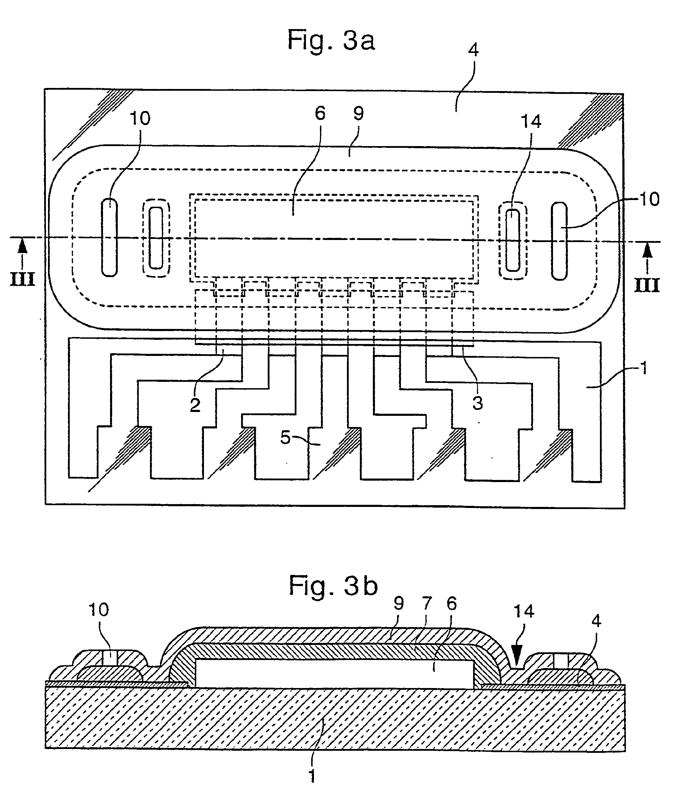

Aux figures 3a et 3b, on réalise la capsule métallique en déposant par voie électrolytique une deuxième couche métallique 9 sur la première couche métallique sacrificielle 7 et sur la couche d'accrochage 4 ou sur des zones annulaires de la couche d'accrochage entourant la première couche, ladite deuxième couche 9 étant constituée d'un autre métal, tel que de préférence de l'or ou un alliage d'or, ou éventuellement du chrome ou un alliage de chrome. Un ou deux passages 10 en opposition sont prévus dans ladite deuxième couche 4 pour donner accès à la première couche sacrificielle 7 afin de la dissoudre sélectivement par rapport aux autres couches métalliques. Lesdits passages 10 sont montrés de forme oblongue, mais il est bien clair qu'ils pourraient être également de forme circulaire ou carrée.

Chaque pilier 14 ou renfort de soutien réalisé par le dépôt de cette deuxième couche 9 est disposé entre un des passages 10 et le microsystème 6 correspondant. Cette capsule présente de ce fait une fermeture hermétique sur sa périphérie à l'exception des deux passages 10, ainsi que les deux piliers de soutien 14 pour pouvoir contenir toute déformation qui pourrait être provoquée lors de la fermeture finale des passages de la capsule. Ledit métal de la capsule doit en outre être malléable et contenir peu de tensions internes et présenter une bonne caractéristique de recouvrement ainsi qu'une très faible porosité.

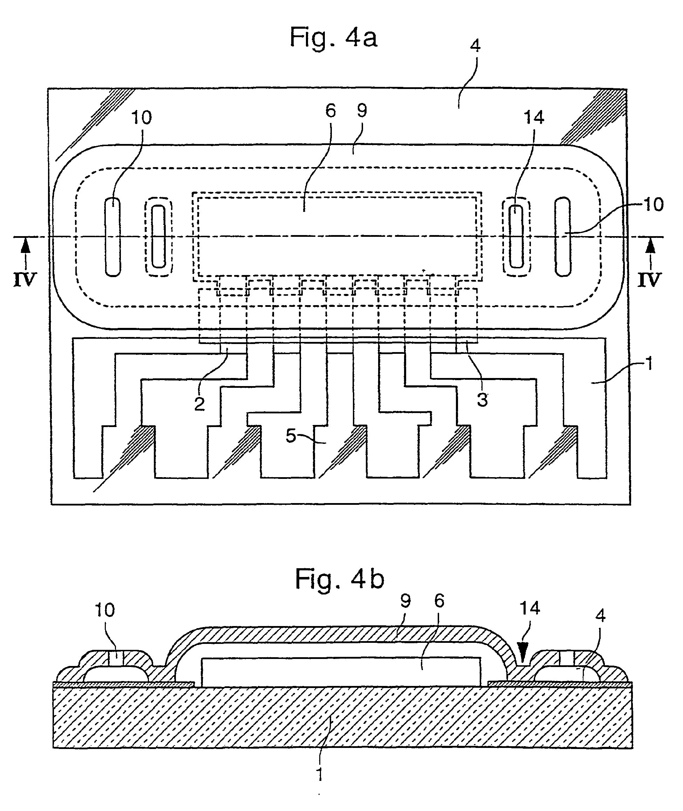

Les piliers de soutien 14 sont entourés par la première couche sacrificielle 7 afin de permettre le retrait de cette couche par un liquide de gravure chimique, comme expliqué avec les figures 4a et 4b suivantes, en passant à côté desdits piliers 14. Bien entendu, il suffit que la première couche passe au moins d'un côté de chaque pilier ou renfort, comme expliqué ci-dessus pour la réalisation desdites ouvertures, pour pouvoir retirer cette couche lors de la gravure chimique.

Bien qu'un seul passage 10 et un seul pilier de soutien 14 puissent être envisagés pour la réalisation de la capsule, il est préférable d'avoir deux ou plusieurs passages pour le retrait de la couche sacrificielle 7; en ayant par exemple deux passages 10 en opposition, cela facilite le retrait de la couche sacrificielle et le nettoyage de l'intérieur de la capsule par circulation des solutions de traitement.

Comme expliqué en référence aux figures 2a et 2b à propos du dépôt de la première couche métallique 7, on utilise également une couche de photorésist, non représentée, qu'on illumine à travers un masque pour pouvoir retirer des parties de photorésist afin d'avoir accès à la première couche et à des zones annulaires de la couche d'accrochage autour de chaque partie de la première couche. Les zones annulaires sont situées au-dessus de l'isolation 3 et sans contact avec l'extrémité des bandes conductrices 2 pour la connexion électrique externe des microsystèmes 6.

Bien entendu, si on utilise des trous conducteurs à travers le substrat 1 pour la connexion externe des microsystèmes 6, le dépôt de la deuxième couche métallique 9 peut se faire au-delà des zones annulaires sur toute la surface du substrat tout en gardant la réalisation des passages 10 pour donner accès à la couche sacrificielle 7.

Aux figures 4a et 4b, la couche d'enrobage sacrificielle 7 est dissoute par gravure chimique au travers des deux passages 10 de façon sélective sans toucher les métaux du microsystème 6, par exemple le fer et le nickel. Le bain de dissolution ne doit occasionner aucun dommage au microsystème 6 ou à la capsule métallique 9 que ce soit par gravure chimique ou par réaction violente avec la couche d'enrobage sacrificielle 7. Il ne doit en outre subsister aucun résidu à l'intérieur de la capsule métallique, au risque de dégazer après la fermeture finale de celle-ci.

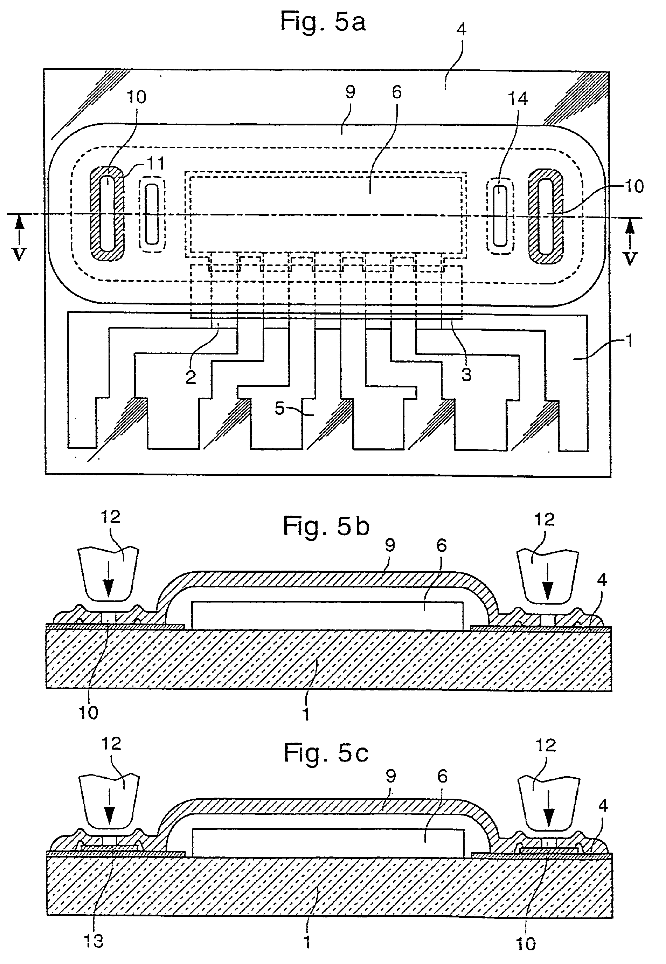

Aux figures 5a et 5b, les microsystèmes 6 encapsulés sont encore solidaires du substrat. Dans cette étape, on doit refermer les passages 10 de la capsule métallique dans une atmosphère inerte ou réductrice. On approche un outil adéquat 12 qui balaie l'intérieur de ladite capsule 9 avec un gaz de protection. Une fois que la capsule est nettoyée de son atmosphère d'origine, l'outil effectue une compression des parties 11 autour de chaque passage 10 et ensuite une opération de soudage par thermocompression ou par ultrasons des parties 11 sur la couche de base de la couche d'accrochage 4 pour pouvoir fermer de façon étanche la capsule métallique. Les piliers de soutien 14, dans cette opération, servent à empêcher que la déformation se propage en direction du microsystème 6. La capsule métallique 9 forme ainsi une protection hermétique au-dessus du microsystème 6.

A la figure 5c, pour diminuer l'énergie nécessaire à la fermeture de la capsule, il est prévu des plots de soudure 13 faisant partie de la couche d'accrochage, comme décrit ci-dessus. La thermocompression des parties 11 autour des passages 10 de la couche métallique 9 sur lesdits plots de soudure assure la fonte desdits plots et la fermeture étanche des passages 10.

L'étape finale, non représentée sur les figures, consiste à séparer par découpage du substrat la multitude de microsystèmes encapsulés, afin de pouvoir les utiliser par exemple dans des conditions ambiantes habituelles, ou encore on peut prévoir d'enrober avant ou après le découpage chaque microsystème d'une couche de résine afin d'assurer une meilleure protection mécanique.

Si la couche métallique finale 9 était du chrome, on pourrait éviter de créer des piliers de soutien, car étant donné que le chrome n'est pas ductile, on doit éviter de le déformer lors de la fermeture des passages 10. Dans ce cas, il serait possible de refermer de façon étanche chaque capsule métallique en déposant une goutte de soudure sur chaque passage à solidifier. Néanmoins, l'or ou l'alliage d'or se prête mieux à la réalisation de la capsule, car il est ductile et résiste à différents liquides de gravure chimique.

Le microsystème 6 construit sur la plaque ou substrat isolant, qui peut être une couche d'oxyde de silicium réalisée sur une plaque de silicium, est d'une hauteur totale de l'ordre de 50 µm avant son encapsulation finale. La hauteur totale lorsque la capsule métallique est terminée sur le microsystème est de l'ordre de 100 µm, voire de 150 µm max. avec une épaisseur métallique de la capsule de l'ordre de 15 à 20 µm. On réalise donc des composants compacts par le procédé objet de l'invention.

Dans le cas d'une conception de toutes les étapes du procédé sur une seule face, on peut imaginer encore après la réalisation de l'encapsulation de réduire l'épaisseur du substrat par attaque chimique du dos du substrat et avant sa découpe. Pour cela, on doit prendre les précautions qui s'imposent de façon à ne pas endommager le côté du substrat portant les microsystèmes encapsulés. Toutefois, si le substrat est mince dès le départ, cela évite de devoir réduire son épaisseur en fin de procédé d'encapsulation.

Grâce à la technique de dépôt par voie électrolytique, on peut déposer des couches de métaux d'épaisseur plus importante, ce qui est difficilement réalisable par évaporation thermique ou par pulvérisation cathodique. Cette technique d'électrodéposition permet une réalisation moins chère et plus rapide pour de telles épaisseurs même si de l'or est utilisé pour la réalisation de la capsule, car la conception selon l'art antérieur d'une plaque de verre indépendante du substrat dans laquelle on pratique des évidements pour y placer ou construire, puis enfermer les microsystèmes occasionne plus de temps et de frais.

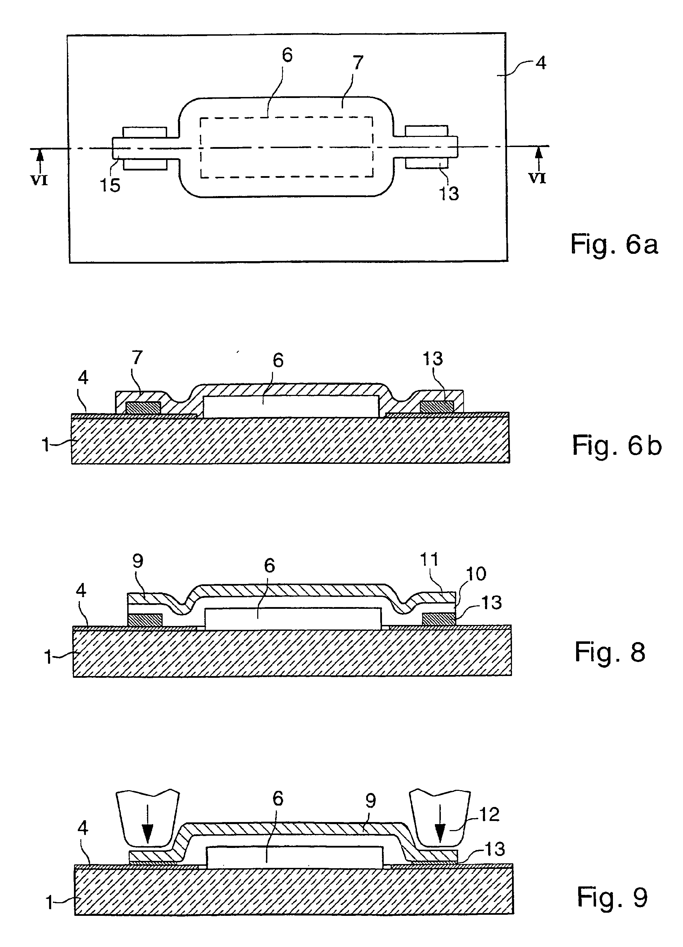

Les figures 6 à 9 montrent des étapes de l'encapsulation hermétique in situ de microsystèmes selon une deuxième forme d'exécution du procédé de l'invention. Il est à noter que les éléments de ces figures, qui correspondent à ceux des figures 1 à 5, portent des signes de référence identiques.

Aux figures 6a et 6b sur lesquelles les bandes conductrices et la couche d'isolation n'ont pas été montrées, une première couche métallique sacrificielle 7, notamment en cuivre ou en alliage de cuivre, est déposée notamment par voie électrolytique sur une zone annulaire de la couche d'accrochage 4 et sur le microsystème 6 pour l'enrober complètement. Deux prolongements 15 de la couche sacrificielle 7, de largeur inférieure à celle enrobant le microsystème 6, passent au-dessus des plots de soudure 13 de la couche d'accrochage 4. Ces deux prolongements 15, servant à la création des passages de la deuxième couche métallique expliquée ci-dessous, sont disposés, ainsi que les deux plots de soudure 13, sur deux côtés opposés de la couche sacrificielle 7.

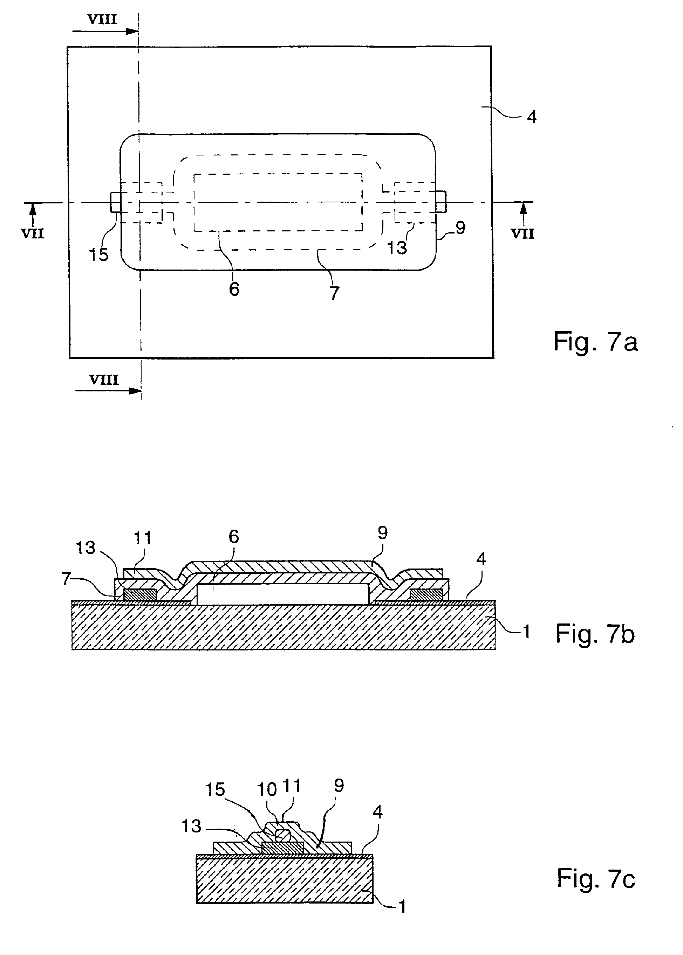

Aux figures 7a et 7b, une deuxième couche métallique 9, notamment en or ou en alliage d'or, est déposée par voie électrolytique sur la couche sacrificielle 7 et sur des parties de la couche d'accrochage. Cette couche 9 définit en vue de dessus une forme rectangulaire s'arrêtant au niveau de l'extrémité de chaque prolongement 15 afin de ne pas les recouvrir complètement et ainsi créer des passages 10 grâce auxdits prolongements 15 sortant de la deuxième couche 9.

A la figure 7c, on peut voir en coupe selon la ligne VIII-VIII de la figure 7a la superposition des différentes couches. Sur le substrat isolant 1, la couche métallique d'accrochage 4 comprend les plots de soudure 13 constitués notamment d'un alliage d'or et d'étain. Au-dessus du plot de soudure 13 passe le prolongement 15 de la couche sacrificielle. La deuxième couche métallique 9 passe au-dessus de la couche sacrificielle et est reliée également de chaque côté du prolongement 15 au plot de soudure 13.

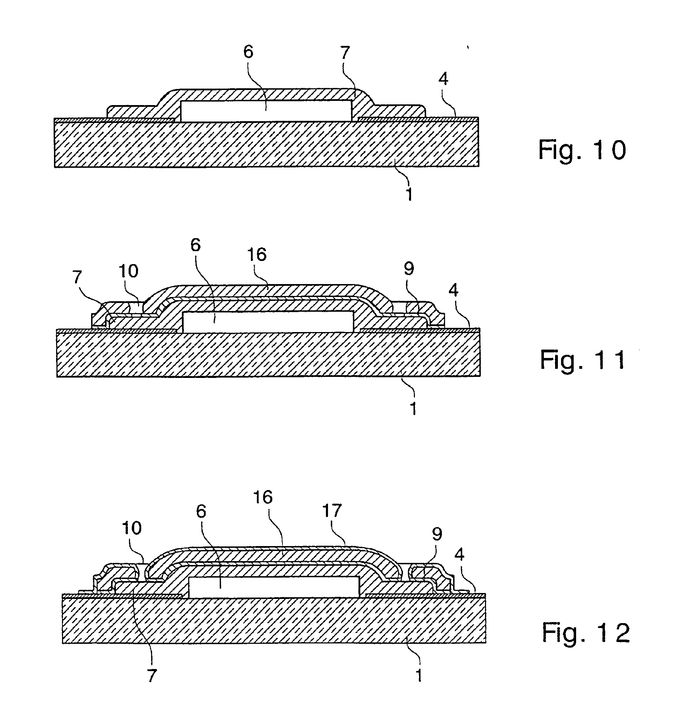

La figure 8 montre le retrait de la couche sacrificielle à l'aide d'un liquide de gravure chimique à travers des passages 10 obtenus par les prolongements de la couche sacrificielle débouchant hors de la deuxième couche. Après ce retrait, le microsystème 6 est libre à l'intérieur de la capsule métallique 9.

La figure 9 montre la fermeture de la capsule 9 à l'aide d'un outil 12 pressant des parties de la deuxième couche 9 se trouvant sur les plots de soudure 13. Lors de la compression de ces parties, les plots de soudure 13 sont chauffés pour être fondus et ainsi obturer les passages 10. Etant donné que les passages sont de taille réduite sur deux côtés renforcés de la deuxième couche 9, il n'est plus nécessaire de prévoir des piliers de renfort comme pour la première forme d'exécution, car la compression des parties délimitant les passages 10 n'endommagera pas le microsystème 6.

Les figures 10 à 15 montrent des étapes de l'encapsulation hermétique in situ de microsystèmes selon une troisième forme d'exécution du procédé de l'invention. Il est à noter que les éléments de ces figures, qui correspondent à ceux des figures 1 à 5, portent des signes de référence identiques.

La figure 10 montre le dépôt notamment par voie électrolytique d'une couche métallique sacrificielle 7, notamment en cuivre ou en alliage de cuivre, sur une zone annulaire de la couche d'accrochage métallique 4 entourant le microsystème 6 et sur ledit microsystème afin de l'enrober complètement. Bien qu'électriquement reliée, la couche sacrificielle 7 déposée sur le microsystème 6 n'est pas contiguë à la couche sacrificielle d'un microsystème voisin sur le même substrat 1, car elle n'est déposée que sur une zone annulaire autour du microsystème respectif.

La figure 11 montre les dépôts successifs par voie électrolytique d'une deuxième couche métallique 9, notamment en or ou en alliage d'or, et d'une troisième couche métallique 16, notamment en cuivre ou en alliage de cuivre comme la couche sacrificielle, au-dessus de la couche sacrificielle 7 et sur une zone annulaire entourant la couche sacrificielle 7. Deux passages 10 sont pratiqués dans les deux couches 9 et 16 pour donner accès à la couche sacrificielle 7. La forme des passages pourrait être oblongue ou circulaire ou carrée.

Un même couche de photorésist est utilisée pour les deux dépôts successifs de métaux. La deuxième couche métallique 9 a une faible épaisseur de l'ordre de 0,5 µm, alors que la troisième couche métallique 16 a une épaisseur de l'ordre de 20 µm pour que la capsule métallique finale résiste aux contraintes mécaniques. Cela permet de réaliser une capsule suffisamment épaisse et de faire des économies étant donné que la deuxième couche est de préférence en or ou en alliage d'or.

Comme la troisième couche 16 est réalisée de préférence d'un même métal que la couche sacrificielle afin d'utiliser les mêmes bains d'électrolyte, il est nécessaire de la protéger d'un liquide de gravure chimique. Pour cela, comme montré en figure 12, une quatrième couche métallique 17 d'un métal identique à la deuxième couche est déposée sur la troisième couche et sur une zone annulaire l'entourant, et vient se connecter à la deuxième couche tout en laissant les passages 10 libres. La troisième couche est de ce fait entièrement insérée entre les deuxième et quatrième couches métalliques et est ainsi protégée de tout liquide de gravure chimique pour le retrait de la couche sacrificielle 7. L'épaisseur de la quatrième couche est de l'ordre de 0,5 µm.

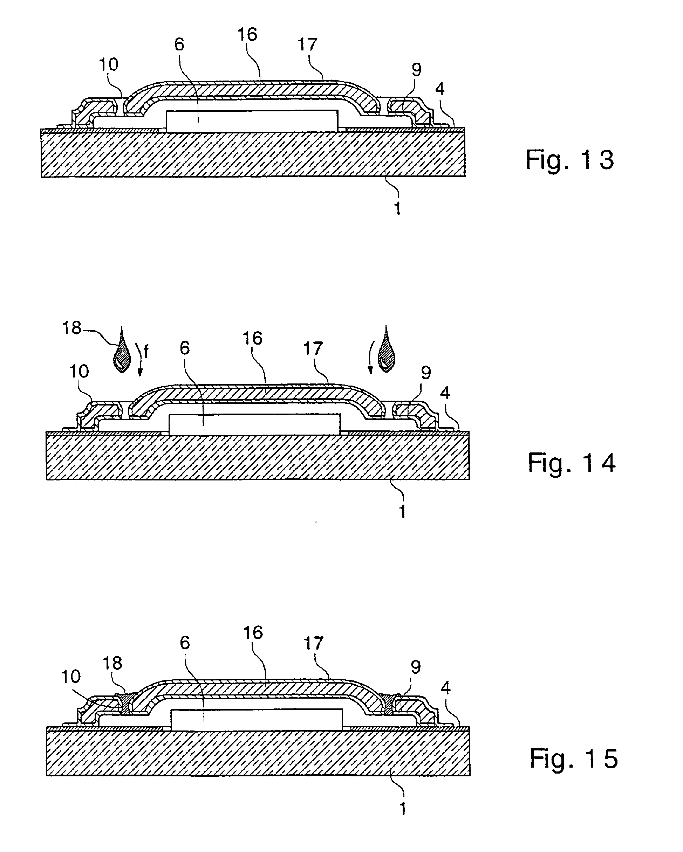

La figure 13 montre le retrait de la couche sacrificielle 7 par un liquide de gravure chimique passant à travers des passages 10 où la troisième couche a été protégée par les deuxième et quatrième couches.

Aux figures 14 et 15 après le retrait de la couche sacrificielle, le microsystème 6 est libre de mouvements dans la capsule, par exemple dans le cas de lames métalliques d'un contacteur. Des gouttes de soudure 18 sont alors amenées par un outil non représenté sur chaque passage 10 dans le sens de la flèche f et sont solidifiées afin d'obturer les passages et de fermer hermétiquement la capsule.

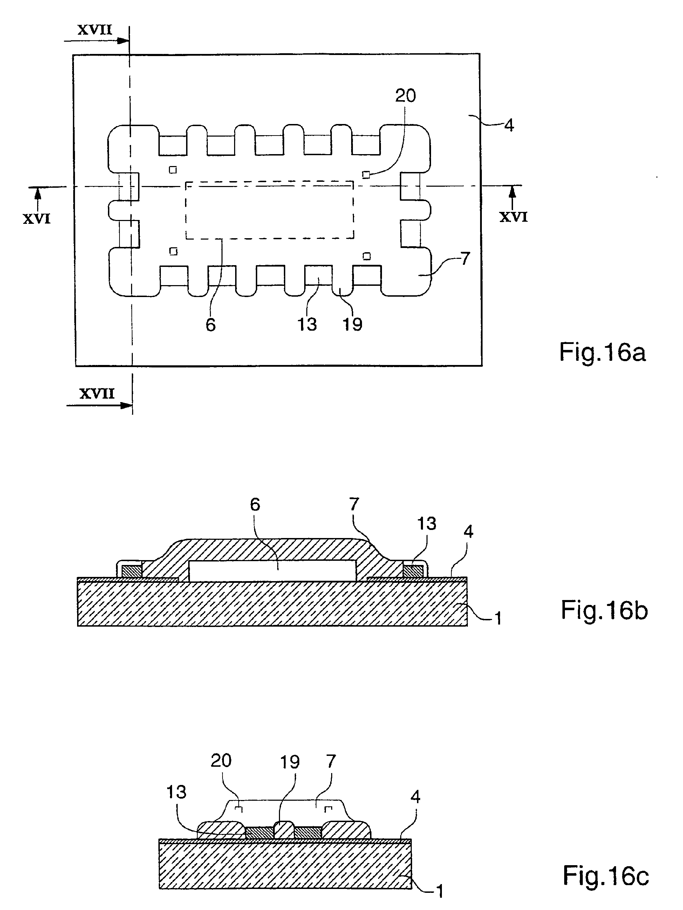

Les figures 16 à 19 montrent des étapes de l'encapsulation hermétique in situ de microsystèmes selon une quatrième forme d'exécution du procédé de l'invention. Il est à noter que les éléments de ces figures, qui correspondent à ceux des figures 1 à 5, portent des signes de référence identiques.

Aux figures 16a, 16b et 16c, une série de plots de soudure 13 de la couche d'accrochage 4 ont été réalisés autour du microsystème 6 dans une étape précédente du procédé, ainsi que des éléments de guidage 20 placés en direction des coins du microsystème et à l'intérieur de la série de plots de soudure. Ces éléments de guidage 20 sont constitués d'un métal différent des plots de soudure 13 et de la couche sacrificielle 7 pour supporter notamment des températures supérieures aux plots de soudure 13. Ils sont utilisés pour le guidage de la deuxième couche 9 lors de la fermeture de la capsule comme discuté plus loin.

Lesdits plots peuvent être espacés régulièrement sur toute la périphérie du microsystème sans être en contact direct avec ledit microsystème 6. Une couche sacrificielle 7 est déposée par voie électrolytique sur le microsystème 6 et sur une zone annulaire de la couche d'accrochage 4 sans passer par-dessus lesdits plots de soudure 13 grâce à un masquage par photorésist. Par contre, des parties 19 de la couche sacrificielle sont disposées dans les espaces entre les plots de soudure afin de pouvoir créer des passages dans la deuxième couche métallique, comme on peut bien le remarquer à la figure 16c qui est une coupe selon la ligne XVII-XVII de la figure 16a.

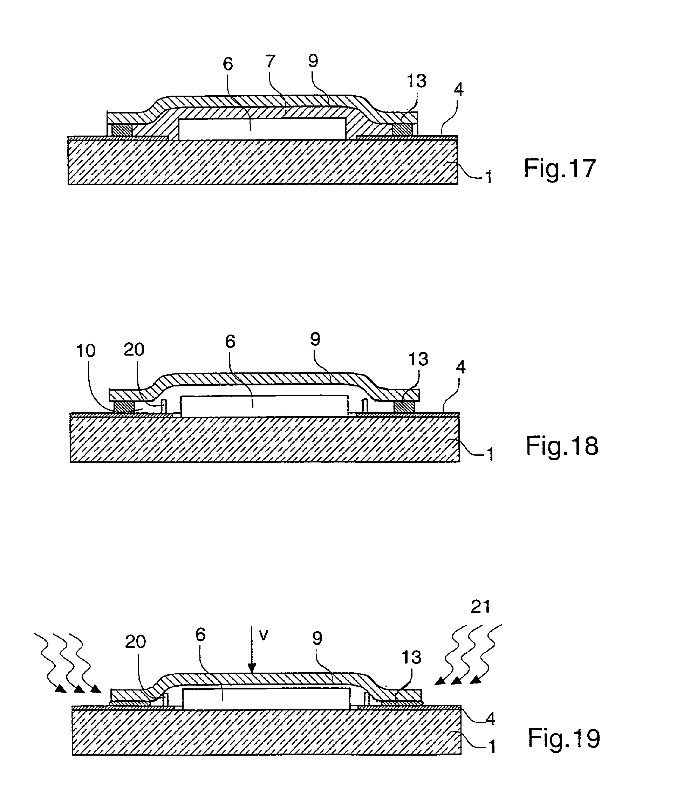

A la figure 17, une deuxième couche métallique 9 est déposée par voie électrolytique sur la couche sacrificielle 7 et sur les plots de soudure 13. La deuxième couche ne vient pas en contact avec la couche de base de la couche d'accrochage 4, car elle ne s'étend pas au-delà du pourtour de la couche sacrificielle 7. Elle laisse de ce fait les parties 19 de la couche sacrificielle émerger de la deuxième couche métallique 9 afin de pouvoir définir des passages 10, visibles en figure 18, dans les espaces entre les plots de soudure 13.

A la figure 18, la couche sacrificielle 7 a été retirée à l'aide d'un liquide de gravure chimique par les parties 19, c'est-à-dire par les passages 10 de la deuxième couche 9. Cette deuxième couche 9 apparaît après le retrait de la couche sacrificielle comme un toit prenant appui sur la série de plots de soudure 13 et abritant le microsystème 6.

La fermeture hermétique de la capsule métallique est montrée en figure 19. Le substrat 1 avec tous les microsystèmes sous leur capsule est placé dans un four pour amener un front de chaleur 21 vers les plots de soudure 13 pour les faire fondre. Dès que les plots de soudure 13 fondent, la capsule 9 s'abaisse dans la direction v par son propre poids et par capillarité pour fermer hermétiquement la microsystème en obturant tous les passages. Comme lors de la fonte des plots de soudure 13, la capsule n'a plus de point d'appui fixe, il se peut qu'elle se déplace dans une direction horizontale et vienne en contact avec le microsystème. Les éléments de guidage 20 montrés au nombre de quatre sur les figures 16 à 19 sont donc prévus pour empêcher que la capsule ne se déplace trop dans la direction horizontale et vienne se fixer sur la couche d'accrochage à l'aide des plots de soudure 13 à un endroit pouvant perturber le bon fonctionnement du microsystème 6.

La forme de bâtonnet donné à titre illustratif dans les figures 16 à 19 pour les éléments de guidage 20 n'est pas limitative, car ces éléments pourraient prendre d'autres formes. On peut par exemple n'employer que deux éléments de guidage 20 disposés près de deux coins opposés du microsystème 6. La forme de ces deux éléments peut être cylindrique ou en forme de L. Bien entendu, l'emploi de ces éléments de guidage n'est pas obligatoire, si l'on arrive à assurer que la descente de la deuxième couche 9 se fasse exclusivement de manière verticale.

Comme les plots de soudure 13 sont en alliage d'or et d'étain ou en alliage d'étain et de plomb et que la deuxième couche 9 venant en appui sur lesdits plots est en or ou en alliage d'or, il y a un risque de diffusion de l'alliage des plots dans la deuxième couche lors de leur fonte par le front de chaleur 21. De ce fait, cela risque de ne plus garantir un espace suffisant pour le microsystème par une quantité de matière fondue trop importante. Afin d'empêcher cette diffusion, il est connu de l'homme du métier de placer une barrière de diffusion entre les plots de soudure 13 et la deuxième couche 9.

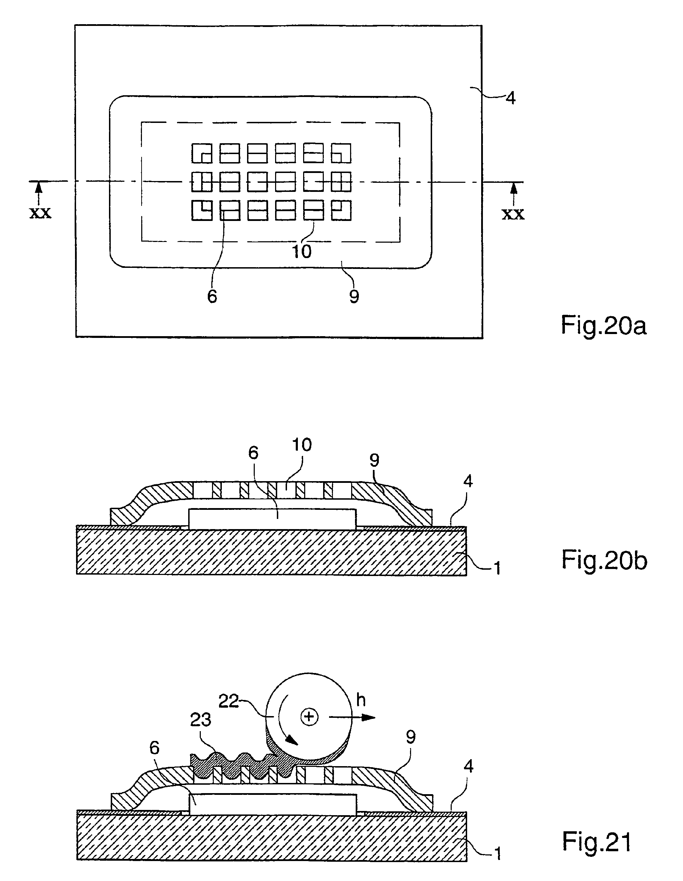

Les figures 20 et 21 montrent deux dernières étapes de l'encapsulation hermétique in situ de microsystèmes selon une cinquième forme d'exécution du procédé de l'invention. Il est à noter que les éléments de ces figures, qui correspondent à ceux des figures 1 à 5, portent des signes de référence identiques.

Aux figures 20a et 20b, on peut observer la capsule métallique constituée par la deuxième couche métallique 9, notamment en or ou en alliage d'or, avec la multitude de passages 10 pratiqués sur sa partie sommitale, par lesquels la couche sacrificielle a été retirée à l'aide d'un liquide de gravure chimique sélective. Cette capsule a été déposée sur une zone annulaire de la couche d'accrochage 4 autour du microsystème et enferme sans contact ledit microsystème 6.

Les passages 10 sont de taille suffisamment petite pour pouvoir être placés sur la partie sommitale de la capsule et permettre de les obturer par une lame de soudure liquide 23 amenée par un outil cylindrique 22 rotatif et se déplaçant dans une direction h au-dessus du substrat 1, comme ou peut le voir à la figure 21, ou par une vague continue de soudure. Grâce à l'effet de capillarité, la soudure liquide 23 va obturer lesdits passages 10 sans risque de venir en contact avec le microsystème 6.

L'outil cylindrique 22 comporte à l'intérieur un ou plusieurs conduits d'amenée du liquide de soudure 23, non visibles sur la figure 21, qui débouchent par des orifices rapprochés pratiqués sur le pourtour du cylindre afin de créer une lame de soudure liquide 23. La largeur de l'outil est telle qu'elle permet en un seul passage sur le substrat d'obstruer tous les passages 10 pratiqués dans la deuxième couche de tous les microsystèmes encapsulés. Il est à noter que la planéité des parties sommitales de la deuxième couche est de l'ordre de plus ou moins 10 µm, de sorte que l'outil peut sans trop de difficulté obturer tous les passages en une seule fois.

En lieu et place de l'outil rotatif 22 pour obstruer les passages 10, le substrat 1 portant tous les microsystèmes 6 encapsulés par la deuxième couche 9 pourrait être amené au-dessus d'un bain de soudure tout en garantissant de ne pas couvrir les plages de contact reliées aux bandes conductrices qui ont été expliquées aux figures 1 à 5. Pour cette opération, il est possible de laisser le photorésist utilisé pour la formation de la deuxième couche qui protège lesdites plages, ainsi que l'extrémité des bandes conductrices.

Dans cette cinquième forme d'exécution, les passages 10 sont disposés comme une grille sur la partie sommitale de la deuxième couche 9 à l'image de ce qui pourrait être réalisé à la connaissance de l'homme du métier avec une couche de polysilicium poreux. A titre de référence, on peut se reporter à l'article de la 12e IEEE conférence internationale MEMS '99 du 17 au 21 janvier 1999, intitulé « Micro Electro Mechanical Systems » aux pages 470 à 475. Cette couche de polysilicium est employée dans certaines réalisations d'encapsulations de microsystèmes pour le retrait d'une couche sacrificielle par un liquide de gravure chimique passant par ledit polysilicium poreux.

Le procédé d'encapsulation qui vient d'être décrit aurait pu s'appliquer également pour l'encapsulation d'un unique microsystème monté sur un substrat, mais dans l'optique de réduire au maximum les coûts de fabrication dans ce domaine des dispositifs micrométriques, il est plus rentable d'encapsuler plusieurs microsystèmes sur un substrat commun en même temps.

D'autres variantes de réalisation ou combinaisons des formes d'exécution précédentes pour une encapsulation métallique hermétique de microsystèmes non explicitées ci-devant, mais à la portée de l'homme du métier, peuvent être encore imaginées sans sortir du cadre de l'invention défini par les revendications.

## Revendications

1. Procédé d'encapsulation hermétique in situ de microsystèmes, dans lequel dans une première phase on monte sur un substrat (1) commun plusieurs microsystèmes (6) entourés par une couche métallique d'accrochage (4) déposée sur le substrat, **caractérisé en ce que**, dans une deuxième phase, on dépose dans une opération commune de dépôt une première couche métallique (7) sur chaque microsystème (6) et sur une zone annulaire (7a) de la couche d'accrochage (4) entourant chaque microsystème (6) de façon à recouvrir complètement chaque microsystème par débordement, **en ce qu'**on dépose une deuxième couche métallique (9) par voie électrolytique sur la première couche métallique (7) et sur la couche d'accrochage (4) de façon à recouvrir la première couche (7) sur une majeure partie de sa surface en laissant au moins un passage (10) par microsystème (6) dans la deuxième couche (9) pour donner accès à la première couche (7), le métal de la première couche étant différent des métaux de la couche d'accrochage, de la deuxième couche et du microsystème, **en ce qu'**on retire par gravure chimique sélective la première couche (7) au travers de chaque passage (10) de la deuxième couche (9), et **en ce qu'**on referme ensuite lesdits passages (10) pour obtenir des capsules métalliques enfermant hermétiquement chaque microsystème.

2. Procédé selon la revendication 1, **caractérisé en ce que** la première couche (7) est déposée par voie électrolytique.

3. Procédé selon la revendication 1, **caractérisé en ce que** la première couche (7) enrobant chaque microsystème comporte au moins deux ouvertures (8) disposées chacune entre le microsystème (6) et le passage (10) correspondant de la deuxième couche (9), et **en ce que** la deuxième couche (9) s'étend dans chacune des ouvertures (8) jusqu'à la couche d'accrochage (4) de façon à créer un pilier de soutien (14) de la deuxième couche (9) entre chaque passage (10) et le microsystème (6) correspondant.

4. Procédé selon la revendication 1, **caractérisé en ce que** lesdits passages (10) sont formés au moyen de deux prolongements (15) en opposition de la première couche (7) pour chaque microsystème (6), lesdits prolongements (15) débouchant hors de la deuxième couche (9), dont la largeur ne varie pas entre lesdits prolongements (15) de manière à créer un renfort au niveau des passages (10).

5. Procédé selon la revendication 1, **caractérisé en ce que** la deuxième couche (9) est déposée de manière à enfermer la première couche (7) à l'exception d'une multitude de passages (10) de dimension réduite disposée sur les parties sommitales de la deuxième couche (9) au-dessus de chaque microsystème.

6. Procédé selon la revendication 5, **caractérisé en ce que** la fermeture des passages (10) disposés sur les parties sommitales de la deuxième couche s'opère en déposant une goutte de soudure (18) à solidifier sur chaque passage ou en faisant passer une lame de fluide de soudure (23) à solidifier pour obstruer tous lesdits passages (10).

7. Procédé selon l'une des revendications 1 à 4, **caractérisé en ce que** la fermeture des passages (10) s'opère en chauffant et comprimant des parties (11) de la deuxième couche (9) autour de chaque passage (10) et en les soudant sur la couche d'accrochage (4).

8. Procédé selon la revendication 7, **caractérisé en ce que** la couche d'accrochage (4) comprend des plots d'un métal de soudure (13) disposés sur une couche métallique de base de ladite couche d'accrochage (4) et aux endroits des passages (10) de la deuxième couche de façon à obturer lesdits passages (10) lors de la thermocompression des parties (11) de la deuxième couche.

9. Procédé selon la revendication 1, **caractérisé en ce que** la deuxième couche prend appui sur des plots de métal de soudure (13) de la couche d'accrochage (4) répartis sur le périmètre de chaque zone annulaire entourant le microsystème (6) correspondant, et **en ce qu'**une partie de la première couche (7) est disposée entre des plots de métal de soudure voisins (13) pour déboucher hors de la deuxième couche (9) et pour définir plusieurs passages (10) de la deuxième couche (9) par microsystème (6).

10. Procédé selon la revendication 9, **caractérisé en ce que** la fermeture des passages (10) pour chaque microsystème (6) s'opère en chauffant les plots de métal de soudure (13) pour faire descendre la deuxième couche (9) au niveau d'une couche de base de la couche d'accrochage (4) et sceller hermétiquement les capsules sur les microsystèmes (6).

11. Procédé selon la revendication 10, **caractérisé en ce que** des éléments de guidage (20) des capsules sont fixés sur la couche d'accrochage (4) avant d'être enrobés par la première couche (7), lesdits éléments restant après le retrait de la première couche et servant à guider verticalement les capsules lors de la descente de la deuxième couche (9) pour la fermeture des passages (10).

12. Procédé selon l'une des revendications précédentes, **caractérisé en ce que** le métal de la première couche (7) est du cuivre ou un alliage de cuivre, et **en ce que** le métal de la deuxième couche (9) est de l'or ou en alliage d'or.

13. Procédé selon l'une des revendications précédentes, **caractérisé en ce que** la couche métallique de base de la couche d'accrochage (4) est faite d'un premier niveau métallique d'accrochage sur le substrat en titane ou en chrome, d'un second niveau métallique en nickel ou en palladium ou en rhodium ou en ruthénium ou en molybdène ou en platine en tant que barrière de diffusion pour la soudure, et un troisième niveau métallique en or en tant que protection d'oxydation.

14. Procédé selon la revendication 1, **caractérisé en ce qu'**on dépose une troisième couche métallique (16) sur la deuxième couche (9) sans obstruer les passages (10) de la deuxième couche, **en ce qu'**on dépose une quatrième couche métallique (17) sur la troisième couche (16) afin d'enfermer complètement la troisième couche (16) entre la deuxième couche (9) et la quatrième couche (17) sans obstruer les passages (10) de la deuxième couche, le métal de la deuxième couche (9) étant le même que le métal de la quatrième couche (17), et **en ce qu'**on retire par gravure chimique sélective la première couche (7) au travers de chaque passage (10).

15. Procédé selon la revendication 1, **caractérisé en ce que**, avant le montage des microsystèmes (6), des bandes conductrices (2) pour la connexion électrique externe de chaque microsystème (6) sont réalisées sur le substrat, **en ce qu'**une couche isolante (3) est déposée sur la partie médiane de la longueur des bandes (2), laissant libres leurs extrémités pour une connexion électrique, et **en ce que** la couche d'accrochage (4) est ensuite déposée de façon à passer sur l'isolation des bandes et structurée de façon à définir des pistes métalliques connectées à une des extrémités des bandes conductrices (2), l'autre extrémité des bandes étant connectée au microsystème (6) correspondant.

16. Procédé selon la revendication 1, **caractérisé en ce que**, avant le montage des microsystèmes (6), on réalise une série de trous conducteurs à travers une partie isolante du substrat (1) pour la connexion électrique externe de chaque microsystème (6), et **en ce que** des plages métalliques sont connectées aux trous conducteurs sur la surface du substrat opposée aux microsystèmes (6).

17. Procédé selon la revendication 1, **caractérisé en ce qu'**après la fermeture des capsules, on les recouvre d'une couche de résine de protection.

18. Procédé selon l'une des revendications précédentes, **caractérisé en ce qu'**après la fermeture des capsules métalliques, on découpe le substrat afin de séparer chaque microsystème (6) encapsulé ayant des plages de contact métalliques (5) accessibles extérieurement.

## Claims

1. Method for hermetically encapsulating microsystems in situ wherein, in a first phase, several microsystems (6) are mounted on a common substrate (1), said microsystems being surrounded by a metal adhesion layer (4) deposited on the substrate, the method being **characterised in that**, in a second phase, in a common deposition step a first metal layer (7) is deposited on each microsystem (6) and on an annular zone (7a) of the adhesion layer (4) surrounding each microsystem (6), so as to completely cover each microsystem by overlap, **in that** a second metal layer (9) is deposited by electrolytic means on the first metal layer (7) and on the adhesion layer (4) so as to cover the first layer (7) over most of its surface leaving at least one passage (10) per microsystem (6) in the second layer (9) to provide access to the first layer (7), the metal of the first layer being different from the metals of the adhesion layer, the second layer and the microsystem, **in that** the first layer (7) is removed by selective chemical etching through each passage (10) of the second layer (9), and **in that** said passages are then closed to obtain metal capsules hermetically enclosing each microsystem.

2. Method according to claim 1, **characterised in that** the first layer (7) is deposited by electrolytic means.

3. Method according to claim 1, **characterised in that** the first layer (7) coating each microsystem includes at least two openings (8) each arranged between the microsystem (6) and the corresponding passage (10) of the second layer (9), and **in that** the second layer (9) extends into each of the openings (8) as far as the adhesion layer (4) so as to create a support pillar (14) for the second layer (9) between each passage (10) and the corresponding microsystem (6).

4. Method according to claim 1, **characterised in that** said passages (10) are formed by means of two extensions (15) facing the first layer (7) for each microsystem (6), said extensions (15) coming out outside the second layer (9), the width of which does not vary between said extensions (15) so as to create a reinforcing part at the passages (10).

5. Method according to claim 1, **characterised in that** the second layer (9) is deposited so as to enclose the first layer (7) with the exception of a multitude of passages (10) of reduced dimensions arranged on the top portions of the second layer (9) above each microsystem.

6. Method according to claim 5, **characterised in that** the passages (10) arranged on the top portions of the second layer are closed by depositing a drop of solder (18) to be solidified on each passage or by causing a wave of liquid solder (23) to be solidified to close all said passages (10).

7. Method according to any of claims 1 to 4, **characterised in that** the passages (10) are closed by heating and compressing portions (11) of the second layer (9) around each passage (10) and by soldering them to the adhesion layer (4).

8. Method according to claim 7, **characterised in that** the adhesion layer (4) includes bumps of a soldering metal (13) arranged on a metal base layer of said adhesion layer (4) and at the location of the passages (10) of the second layer so as to close said passages (10) when the portions (11) of the second layer are thermocompressed.

9. Method according to claim 1, **characterised in that** the second layer rests on the soldering metal bumps (13) of the adhesion layer (4) distributed over the perimeter of each annular zone surrounding the corresponding microsystem (6), and **in that** a portion of the first layer (7) is arranged between neighbouring soldering metal bumps (13) to come out outside the second layer (9) and to define several passages (10) of the second layer (9) per microsystem (6).

10. Method according to claim 9, **characterised in that** the passages (10) for each microsystem (6) are closed by heating the soldering metal bumps (13) to cause the second layer (9) to be lowered onto a base layer of the adhesion layer (4) and to hermetically seal the capsules onto the microsystems (6).

11. Method according to claim 10, **characterised in that** guide elements (20) for the capsules are secured to the adhesion layer (4) before being coated by the first layer (7), said elements remaining after removal of the first layer and being used to guide the capsules vertically when the second layer (9) is lowered to close the passages (10).

12. Method according to any of the preceding claims, **characterised in that** the metal of the first layer (7) is copper or a copper alloy, and **in that** the metal of the second layer (9) is gold or a gold alloy.

13. Method according to any of the preceding claims, **characterised in that** the metal base layer of the adhesion layer (4) is made of a first metal fixing layer on the substrate made of titanium or chromium, a second metal layer made of nickel or palladium or rhodium or ruthenium or molybdenum or platinum as a diffusion barrier for the solder, and a third metal layer made of gold as oxidation protection.

14. Method according to claim 1, **characterised in that** a third metal layer (16) is deposited on the second layer (9) without closing the passages (10) of the second layer, **in that** a fourth metal layer (17) is deposited on the third layer (16) in order to completely enclose the third layer (16) between the second layer (9) and the fourth layer (17) closing obstructing the passages (10) of the second layer, the metal of the second layer (9) being the same as the metal of the fourth layer (17), and **in that** the first layer (7) is removed by selective chemical etching through each passage (10).

15. Method according to claim 1, **characterised in that**, prior to mounting the microsystems (6), conductive strips (2) for the external electric connection of each microsystem (6) are made on the substrate, **in that** an insulating layer (3) is deposited on the median portion of the length of the strips (2), leaving their ends free for an electric connection, and **in that** the adhesion layer (4) is then deposited so as to pass over the insulation of the strips and structured so as to define metal paths connected to one of the ends of the conductive strips (2), the other end of the strips being connected to the corresponding microsystem (6).

16. Method according to claim 1, **characterised in that**, prior to mounting the microsystems (6), a series of conductive holes are made through an insulating part of the substrate (1) for the external electric connection of each microsystem (6), and **in that** metal pads are connected to the conductive holes on the surface of the substrate opposite the microsystems (6).

17. Method according to claim 1, **characterised in that** after closing the capsules, they are covered with a protective layer of resin.

18. Method according to one of the preceding claims, **characterised in that** after closing the metal capsules, the substrate is cut or diced in order to separate each encapsulated microsystem (6) having metal contact pads (5) which are accessible from the exterior.

## Patentansprüche

1. Verfahren zum hermetischen Einkapseln von Mikrosystemen vor Ort, bei dem in einer ersten Phase auf ein gemeinsames Substrat (1) mehrere Mikrosysteme (6) montiert werden, die von einer auf dem Substrat abgelagerten metallischen Brückenbildungsschicht (4) umgeben sind, **dadurch gekennzeichnet, dass** in einer zweiten Phase in einer gemeinsamen Ablagerungsoperation eine erste metallische Schicht (7) auf jedem Mikrosystem (6) und auf einer Ringzone (7a) der jedes Mikrosystem (6) umgebenden Brückenbildungsschicht (4) abgelagert wird, derart, dass jedes Mikrosystem durch Überlappung vollständig abgedeckt ist, dass eine zweite metallische Schicht (9) auf elektrolytischem Weg auf der ersten metallischen Schicht (7) und auf der Brückenbildungsschicht (4) abgelagert wird, derart, dass die erste Schicht (7) auf einem Hauptteil ihrer Oberfläche abgedeckt ist, indem wenigstens ein Durchgang (10) pro Mikrosystem (6) in der zweiten Schicht (9) freigelassen wird, um einen Zugang zu der ersten Schicht (7) zu schaffen, wobei das Metall der ersten Schicht von den Metallen der Brückenbildungsschicht, der zweiten Schicht und des Mikrosystems verschieden ist, dass durch selektive chemische Ätzung die erste Schicht (7) durch jeden Durchlass (10) der zweiten Schicht (9) entfernt wird und dass anschließend die Durchlässe (10) verschlossen werden, um metallische Kapseln zu erhalten, die jedes Mikrosystem hermetisch einschließen.

2. Verfahren nach Anspruch 1, **dadurch gekennzeichnet, dass** die erste Schicht (7) auf elektrolytischem Weg abgelagert wird.

3. Verfahren nach Anspruch 1, **dadurch gekennzeichnet, dass** die erste Schicht (7), die jedes Mikrosystem umhüllt, wenigstens zwei Öffnungen (8) aufweist, die jeweils zwischen dem Mikrosystem (6) und dem der zweiten Schicht (9) entsprechenden Durchlass angeordnet sind, und dass sich die zweite Schicht (9) in jede der Öffnungen (8) bis zu der Brückenbildungsschicht (4) erstreckt, derart, dass zwischen jedem Durchlass (10) und dem entsprechenden Mikrosystem (6) eine Haltestütze (14) der zweiten Schicht (9) erzeugt wird.

4. Verfahren nach Anspruch 1, **dadurch gekennzeichnet, dass** die Durchlässe (10) mittels zweier Verlängerungen (15) gegenüber der ersten Schicht (7) für jedes Mikrosystem (6) gebildet sind, wobei die Verlängerungen (15) aus der zweiten Schicht (9) hervorstehen, deren Breite sich zwischen den Verlängerungen (15) nicht ändert, derart, dass auf Höhe der Durchlässe (10) eine Verstärkung geschaffen wird.

5. Verfahren nach Anspruch 1, **dadurch gekennzeichnet, dass** die zweite Schicht (9) in der Weise abgelagert wird, dass sie die erste Schicht (7) mit Ausnahme mehrerer Durchlässe (10) mit verringerter Abmessung, die auf den Scheitelbereichen der zweiten Schicht (9) über jedem Mikrosystem angeordnet sind, umhüllt.

6. Verfahren nach Anspruch 5, **dadurch gekennzeichnet, dass** das Verschließen der auf den Scheitelbereichen der zweiten Schicht angeordneten Durchlässe (10) **dadurch** erfolgt, dass ein Lötmitteltropfen (18), der sich verfestigen soll, auf jedem Durchlass abgelagert wird oder dass ein Lötmittelfluidschwall (23), der sich verfestigen soll, darüber geschickt wird, um alle Durchlässe (10) zu verschließen.

7. Verfahren nach einem der Ansprüche 1 bis 4, **dadurch gekennzeichnet, dass** das Verschließen der Durchlässe (10) **dadurch** erfolgt, dass Teile (11) der zweiten Schicht (9) um jeden Durchlass (10) erwärmt und komprimiert werden und dass sie auf die Brückenbildungsschicht (4) gelötet werden.

8. Verfahren nach Anspruch 7, **dadurch gekennzeichnet, dass** die Brükkenbildungsschicht (4) Höcker aus einem Lötmetall (13) umfasst, die auf einer metallischen Basisschicht der Brückenbildungsschicht (4) und an den Stellen der Durchlässe (10) der zweiten Schicht angeordnet sind, derart, dass die Durchlässe (10) verschlossen werden, wenn die Teile (11) der zweiten Schicht einer Wärmekompression unterworfen werden.

9. Verfahren nach Anspruch 1, **dadurch gekennzeichnet, dass** sich die zweite Schicht auf den Lötmetall-Höckern (13) der Brückenbildungsschicht (4), die am Umfang jeder das entsprechende Mikrosystem (6) umgebenden Ringzone verteilt sind, abstützt und dass ein Teil der ersten Schicht (7) zwischen benachbarten Lötmetall-Höckern (13) angeordnet ist, um von der zweiten Schicht (9) vorzustehen und um mehrere Durchlässe (10) der zweiten Schicht (9) pro Mikrosystem (6) zu definieren.

10. Verfahren nach Anspruch 9, **dadurch gekennzeichnet, dass** das Verschließen der Durchlässe (10) für jedes Mikrosystem **dadurch** erfolgt, dass die Lötmetall-Höcker (13) erhitzt werden, um die zweite Schicht (9) auf die Höhe einer Basisschicht der Brückenbildungsschicht (4) abzusenken und um die Kapseln auf den Mikrosystemen (6) hermetisch zuzuschmelzen.

11. Verfahren nach Anspruch 10, **dadurch gekennzeichnet, dass** an der Brückenbildungsschicht (4) Führungselemente (20) der Kapseln befestigt werden, bevor sie durch die erste Schicht (7) umhüllt werden, wobei diese Elemente nach dem Entfernen der ersten Schicht zurückbleiben und der vertikalen Führung der Kapseln beim Absenken der zweiten Schicht (9) zum Verschließen der Durchlässe (10) dienen.

12. Verfahren nach einem der vorhergehenden Ansprüche, **dadurch gekennzeichnet, dass** das Metall der ersten Schicht (7) Kupfer oder eine Kupferlegierung ist und dass das Metall der zweiten Schicht (9) Gold oder eine Goldlegierung ist.

13. Verfahren nach einem der vorhergehenden Ansprüche, **dadurch gekennzeichnet, dass** die metallische Basisschicht der Brückenbildungsschicht (4) aus einer ersten metallischen Brückenbildungsebene auf dem Substrat aus Titan oder Chrom, aus einer zweiten metallischen Ebene aus Nickel oder aus Palladium oder aus Rhodium oder aus Ruthenium oder aus Molybdän oder aus Platin, die als Diffusionssperre für das Lötmittel dient, und aus einer dritten metallischen Ebene aus Gold, die als Oxidationsschutz dient, hergestellt ist.

14. Verfahren nach Anspruch 1, **dadurch gekennzeichnet, dass** auf der zweiten Schicht (9) eine dritte metallische Schicht (16) abgelagert wird, ohne die Durchlässe (10) der zweiten Schicht zu verschließen, dass auf der dritten Schicht (16) eine vierte metallische Schicht (17) abgelagert wird, um die dritte Schicht (16) zwischen der zweiten Schicht (9) und der vierten Schicht (17) vollständig zu umgeben, ohne die Durchlässe (10) der zweiten Schicht zu verschließen, wobei das Metall der zweiten Schicht (9) gleich dem Metall der vierten Schicht (17) ist, und dass durch selektive chemische Ätzung die erste Schicht (7) durch jeden Durchlass (10) hindurch entfernt wird.

15. Verfahren nach Anspruch 1, **dadurch gekennzeichnet, dass** vor der Montage der Mikrosysteme Leiterstreifen (2) für die äußere elektrische Verbindung jedes Mikrosystems (6) auf dem Substrat verwirklicht werden, dass auf dem Mittelteil in Längsrichtung der Streifen (2) eine Isolierschicht (3) abgelagert wird, wobei deren Enden für einen elektrischen Anschluss freigelassen werden, und dass die Brückenbildungsschicht (4) anschließend in der Weise abgelagert wird, dass sie zur Isolation der Streifen gelangt und so strukturiert ist, dass metallische Bahnen definiert werden, die mit einem der Enden der Leiterstreifen (2) verbunden sind, während das andere Ende der Streifen mit dem entsprechenden Mikrosystem (6) verbunden ist.

16. Verfahren nach Anspruch 1, **dadurch gekennzeichnet, dass** vor der Montage der Mikrosysteme (6) zahlreiche leitende Löcher durch einen isolierenden Teil des Substrats (1) für die äußere elektrische Verbindung jedes Mikrosystems (6) verwirklicht werden und dass mit den leitenden Löchern auf der Oberfläche des Substrats gegenüber den Mikrosystemen (6) metallische Bereiche verbunden werden.

17. Verfahren nach Anspruch 1, **dadurch gekennzeichnet, dass** die Kapseln nach ihrem Verschließen mit einer Schutzharzschicht überzogen werden.

18. Verfahren nach einem der vorhergehenden Ansprüche, **dadurch gekennzeichnet, dass** nach dem Verschließen der metallischen Kapseln das Substrat zerschnitten wird, um jedes eingekapselte Mikrosystem (6), das metallische Kontaktbereiche (5) besitzt, die von außen zugänglich sind, abzutrennen.
